# EUROPEAN PATENT SPECIFICATION

(11) **EP 2 174 169 B1**
(45) Date of publication and mention of the grant of the patent: **31.07.2019**
(21) Application number: 08780619.6
(22) Date of filing: 09.05.2008
(51) Int. Cl.: G02B 5/02, G02B 5/04, H05B 33/00, G02B 26/00

(54) **ORGANIC LIGHT EMITTING DIODE DEVICE WITH LIGHT EXTRACTION FILM**
ORGANISCHE LEUCHTDIODEVORRICHTUNG MIT EINEM LICHTEXTRAKTIONSFILM
DISPOSITIF À DIODE ÉLECTROLUMINESCENTE ORGANIQUE AVEC UN FILM D'EXTRACTION DE LUMIÈRE

(30) Priority: 13.07.2007 US 777453
(43) Date of publication of application: 14.04.2010
(73) Proprietor: 3M Innovative Properties Company, St. Paul, MN 55133-3427 (US)
(72) Inventor: POTTS, John E., Saint Paul, Minnesota 55133-3427 (US); MCCORMICK, Fred B., Saint Paul, Minnesota 55133-3427 (US); WOLK, Martin B., Saint Paul, Minnesota 55133-3427 (US); ZHANG, Jun-Ying, Saint Paul, Minnesota 55133-3427 (US); SMITH, Terry L., Saint Paul, Minnesota 55133-3427 (US); BATTIATO, James M., Saint Paul, Minnesota 55133-3427 (US); WANG, Ding, Saint Paul, Minnesota 55133-3427 (US); TOLBERT, William A., Saint Paul, Minnesota 55133-3427 (US); ROEHRIG, Mark A., Saint Paul, Minnesota 55133-3427 (US); BRIGHT, Clark I., Saint Paul, Minnesota 55133-3427 (US)
(74) Representative: Vossius & Partner Patentanwälte Rechtsanwälte mbB
(86) International application number: PCT/US2008/063209
(87) International publication number: WO 2009/011961

(56) References cited:
- EP-A1- 1 603 367
- WO-A1-2005/115740
- US-A- 5 995 690
- US-A- 6 010 751
- US-A1- 2004 033 369
- US-A1- 2005 007 000
- US-A1- 2005 194 896

## Description

### BACKGROUND

Organic Light Emitting Diodes (OLEDs) are the basis for a new display and lighting technology, providing a good match for high resolution or high pixel count high definition display applications, and for efficient, broad area, flexible lighting applications. OLED devices include a thin film of electroluminescent organic material sandwiched between a cathode and an anode, with one or both of these electrodes being a transparent conductor. When a voltage is applied across the device, electrons and holes are injected from their respective electrodes and recombine in the electroluminescent organic material through the intermediate formation of emissive excitons.

In OLED devices, over 70% of the generated light is typically lost due to processes within the device structure. The trapping of light at the interfaces between the higher index organic and Indium Tin Oxide (ITO) layers and the lower index substrate layers is the major cause of this poor extraction efficiency. Only a relatively small amount of the emitted light emerges through the transparent electrode as "useful" light. The majority of the light undergoes internal reflections, which result in its being emitted from the edge of the device or trapped within the device and eventually being lost to absorption within the device after making repeated passes.

Efforts have been made to improve the internal quantum efficiency (number of photons generated per electron injected) of OLEDs by means such as modifying the charge injection or transport layers, using fluorescent dyes or phosphorescent materials, or by using multilayer structures (see, for example, K.Meerholz, Adv.Funct.Materials v.11, no.4, p251 (2001)). Light extraction efficiency (number of photons emerging from the structure vs. the number generated internally) can be influenced by factors external to the emission layers themselves.

A bottom emitting OLED may be thought of as consisting of a core containing high index of refraction layers (organic layers for light generation, carrier transport, injection or blocking, and, typically, a transparent conductive oxide layer) and a low index of refraction substrate material (typically glass, but could be a polymer film). Therefore light that is generated within the core may encounter two high-index to low-index interfaces where it might undergo internal reflection. Light unable to escape the core as a result of encounter at the first interface is confined to a waveguide mode, while light passing through that interface but unable to escape from the substrate as a result of reflection at the substrate-to-air interface is confined to a substrate mode. Similar optical losses occur due to interfaces in top emitting OLEDs.

Various solutions have been proposed to affect light reaching the substrate-to-air interface by disturbing that interface (e.g., microlenses or roughened surfaces). Others have introduced scattering elements into the substrate or into an adhesive (see Published PCT Application No. WO2002037580A1 (Chou)), thereby interrupting the substrate modes to redirect that light out of the device. There have even been some preliminary attempts to disturb the core-to-substrate interface by introducing scattering or diffractive elements at this interface. Detailed analysis has shown that scattering or diffracting structures will be most effective in extraction light when located at this interface (M.Fujita, et al.; Jpn.J.Appl.Phys. 44 (6A), pp.3669-77 (2005)). Scattering efficiency is maximized when the index contrast between the scattering or diffractive elements and the backfill material is large and when the length scale of the index contrast variations is comparable to the wavelength of the light (see, for example, F.J.P.Schuurmans, et al.; Science 284 (5411), pp.141-143 (1999)).

Fabrication of defect-free OLED devices in contact with this light extracting layer will require a smooth planar surface, so planarity of the top surface of a light extraction film is important. There has been, however, some work on corrugating the electrode structure in order to couple light out of the OLED (M.Fujita, et al.; Jpn.J.Appl.Phys. 44 (6A), pp.3669-77 (2005)); the resultant effects on the electric fields in the device are expected to have deleterious effects. So great care must be taken to not adversely affect the electrical operation of the device while disturbing this interface. Practical solutions to balancing these conflicting issues have not yet been proposed.

Similar problems in external efficiency exist with inorganic light-emitting diodes (LEDs), where the very high refractive indices of the active materials can severely limit the extraction of internally generated light. In these cases, there have been some attempts to utilize photonic crystal (PC) materials to improve the extraction efficiency (S.Fan, Phys.Rev.Letters v.78, no.17, p.3294 (1997); H.Ichikawa, Appl.Phys.Letters V.84, p.457 (2004)). Similar reports on the use of PCs in connection with OLED efficiency improvement have begun to appear (M.Fujita, Appl.Phys.Letters v.85, p.5769 (2004); Y.Lee, Appl.Phys.Letters v.82, p.3779 (2003)), but previously reported results have involved time-consuming and costly procedures which do not lend themselves incorporation into existing OLED fabrication processes.

EP 1 603 367 A discloses an OLED device according to the preamble of claim 1.

Accordingly, a need exists for a product which can enhance light extraction from OLED devices in a form which is compatible with fabrication processes for these devices.

### SUMMARY

The present invention is defined by the claims.

The device may optionally have additional layers added to or incorporated within it to effect additional functionalities beyond improvement of light extraction efficiency; these additional functionalities may include mechanical support, barrier protection, electrical conductance, spectral modification, or polarization.

### BRIEF DESCRIPTION OF THE DRAWINGS

The accompanying drawings are incorporated in and constitute a part of this specification and, together with the description, explain the advantages and principles of the invention. In the drawings,
FIG. 1 is a diagram of a bottom emitting OLED display device with a light extraction film which is not an embodiment of the invention;
FIG. 2 is a diagram of a top emitting OLED display device with a light extraction film;
FIG. 3 is a diagram illustrating spatially modulated OLEDs for a solid state lighting element;
FIG. 4 is a diagram of an OLED backlight unit with a light extraction film;
FIG. 5 is a diagram illustrating OLEDs used as an LCD backlight unit;
FIGS. 6-9 are diagrams depicting possible spatial configurations of extraction elements; and
FIGS. 10-14 are diagrams depicting possible surface configurations of extraction elements.

### DETAILED DESCRIPTION

Disclosed are methods to form light-extracting nanostructures, or other nanostructures, in a polymer replication process, a direct deposition of nanoparticles, or other processes to make a light extraction film for OLED devices. The multifunctional film product can, in addition to enhancing light extraction, serve additional functions such as a substrate, encapsulant, barrier layer, filter, polarizer, or color converter and may be employed either during or after manufacture of an OLED device. The film construction is based upon photonic crystal structures, or other nanostructures, for improved efficiency of light extraction from the devices by modifying the interface between high and low index layers within the device.

Elements of the invention include the provision of structures of dimensions comparable to or less than the wavelength of the light to be controlled, the provision of a material with contrasting index of refraction to fill in the areas surrounding the structures and also to planarize the structure in order to present an essentially smooth surface to come in contact with the OLED structure, and the location of this index-contrasting nanostructured layer within a small enough distance from the light-emitting region to be effective in extracting the light that would otherwise be trapped in that region.

Light incident from a high-index material onto an interface with a lower index medium will undergo total internal reflection (TIR) for all incidence angles greater than the critical angle θ_{C}, defined by θ_{C} = sin⁻¹ (n₂/n₁), where n₁ and n₂ are the refractive indices of the high- and low-index regions, respectively. The electromagnetic field associated with this light reflected by TIR extends into the lower-index region in an evanescent standing wave, but the strength of this field diminishes exponentially with distance from the interface. Absorbing or scattering entities located within this evanescent zone, typically about one wavelength thick, can disrupt the TIR and cause the light to pass through the interface. Therefore, it is preferable that the nanostructured index contrast layer be located within the evanescent zone if it is to be most effective in causing extraction of the light from the emission region by scattering or diffraction.

Replication master tools can be fabricated with regular or random structures of the required average periodicity for light extraction, 200 nanometers (nm)-2000nm, over increasingly larger areas. Combining this tooling capability with microreplication processes such as continuous cast and cure (3C) enable the formation of the photonic crystal structures, or other nanostructures, on the surface of a film substrate. Examples of a 3C process are described in the following patents: U.S. Patent Nos. 4,374,077; 4,576,850; 5,175,030; 5,271,968; 5,558,740; and 5,995,690.

The terms "nanostructure" or "nanostructures" refers to structures having at least one dimension (e.g., height, length, width, or diameter) of less than 2 microns and more preferably less than one micron. Nanostructure includes, but is not necessarily limited to, particles and engineered features. The particles and engineered features can have, for example, a regular or irregular shape. Such particles are also referred to as nanoparticles.

The term "nanostructured" refers to a material or layer having nanostructures.

The term "photonic crystal structures" refers to periodic or quasi-periodic optical nanostructures interspersed with a material of sufficiently different index of refraction that will enable the structure to produce gaps in the spectrum of allowed electromagnetic modes in the material.

The term "index" refers index of refraction.

The term "backfill" refers to the material incorporated into a structure, and of a different index from the structure, to fill in voids in the structure and planarize the structure.

The term "extraction elements" refers to any type and arrangement of nanostructures enhancing light extraction from self-emissive light sources. The extraction elements are preferably not contained within a volume distribution.

### Bottom Emitting OLED Display Device

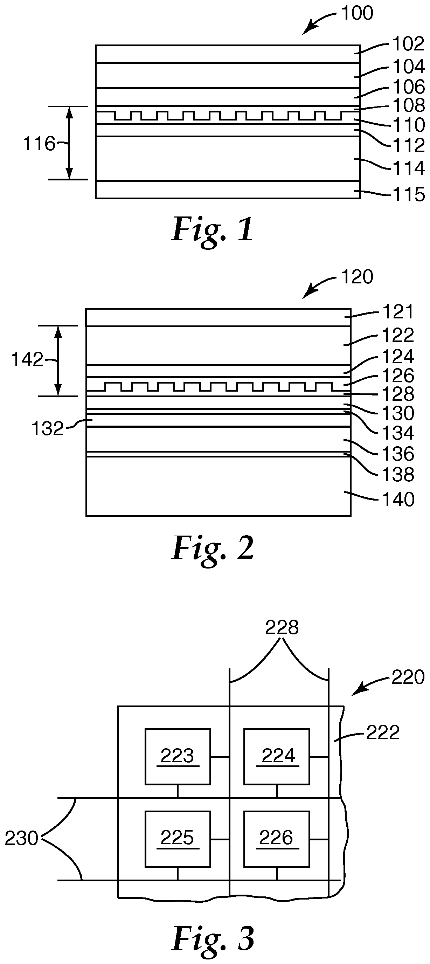

FIG. 1 illustrates a structure of bottom emitting OLED device 100 with a film substrate having a light extraction film. A bottom emitting OLED device is defined as an OLED device emitting light through the substrate. Table 1 describes the exemplary elements of device 100 and the arrangement of those elements, as identified by the reference numbers provided in FIG. 1. Each layer of device 100 can be coated on or otherwise applied to the underlying layer.

| Table 1 - Bottom Emitting OLED Device with Light Extraction Film | |
|---|---|
| Ref. No. | Type of Element |
| 102 | electrode 1 |
| 104 | organic layers |
| 106 | electrode 2 |
| 108 | high index structure |
| 110 | low index structure |
| 112 | optional barrier layer |
| 114 | substrate |
| 115 | optional functional layers |
| 116 | light extraction film |

The substrate 114 is composed of a material, substantially transparent (transmissive) to the desired emitted wavelengths, that provides sufficient mechanical support and thermal stability for the device. Substrate 114 preferably comprises a flexible material. Examples of substrate materials include the following: glass; flexible glass; polyethylene terephthalate ("PET"); polyethylene naphthalate ("PEN"); or other translucent or transparent materials. Substrate 114 can optionally also function as a barrier layer. Also, substrate 114 can optionally contain dyes or particles, and it can be tentered or include prismatic structures.

The optional barrier layer 112 effectively blocks or helps prevent permeation of oxygen and water to the layers of the device, particularly the organic layers. Examples of barrier layers are described in U.S. Patent Application Publication Nos. 2006/0063015 (describing boron oxide layers with inorganic barrier layers) and 2007/0020451 (describing diamond-like glass (DLG) and diamond-like carbon (DLC)).

The electrodes 102 and 106 can be implemented with, for example, transparent conductive oxide (TCO) such as indium tin oxide (ITO) or metals with the appropriate work function to make injection of charge carriers such as calcium, aluminum, gold, or silver.

The organic layers 104 can be implemented with any organic electroluminescent material such as a light-emitting polymer, an example of which is described in U.S. Patent No. 6,605,483. Other examples of suitable light emitting materials include evaporated small molecule materials, light-emitting dendrimers, molecularly doped polymers, and light-emitting electrochemical cells.

The light extraction film 116 is composed of substrate 114, optional barrier layer 112, low index structure 110, and high index structure 108. The high index structure uses a backfill medium to effectively provide a planarizing layer over the low index structure in order to make the light extraction film sufficiently planar to allow OLED fabrication. The backfill layer can alternatively have other optical properties. Also, the backfill layer material can function as a barrier to moisture and oxygen or provide electrical conduction, possibly in addition to having barrier properties, depending upon the type of material used. The backfill layer can alternatively be implemented with an optically clear adhesive, in which case the extraction film can be applied to top emitting OLED device, for example.

The low index structure 110 has a material with an index substantially matched to the underlying layer, typically the substrate. The low index structure 110 is composed of a nanostructured layer, which can have a periodic, quasi-periodic, or random distribution or pattern of optical nanostructures, including photonic crystal structures. It can include discrete nanoparticles. The nanoparticles can be composed of organic materials or other materials, and they can have any particle shape. The nanoparticles can alternatively be implemented with porous particles. The distribution of nanostructures can also have varying pitches and feature size. At least a portion of the extraction elements or nanostructures are preferably in contact with the flexible substrate, and the extraction elements may have voids beneath them. The layer of nanoparticles can be implemented with nanoparticles in a monolayer or with a layer having agglomerations of nanoparticles.

Using a thickness of the nanostructures on the order of the evanescent wave from the organic layers can result in coupling of the evanescent wave to the nanostructures for extraction of additional light from the device. This coupling preferably occurs when the light extraction film is adjacent to the light emitting region of the self-emissive light source. When the backfill layer has a lower index than the structured layer, then the backfill layer preferably has a thickness substantially equal to the extraction elements. When the backfill layer has a higher index than the structured layer, then the backfill layer can be thicker than the extraction elements provided it can still interact with the evanescent wave. In either case, the structured layer and backfill layer are preferably in sufficient proximity to the light output surface in order to at least partially effect the extraction of light from that surface.

The nanostructured features in layer 110 can be fabricated using any printing techniques for replication of submicron features such as the following: imprinting; embossing; nanoimprinting; thermal- or photo-nanoimprint lithography; injection molding; or nanotransfer printing. Another technique for fabricating the extraction elements is described in Example 18 in U.S. Patent No. 6,217,984.

The high index structure 108 is a high index material providing index contrast to the adjacent low index nanostructured layer and provides an effective planarization layer to it. The index of refraction mismatch between nanostructured layer 110 and backfill medium 108 at the emission wavelength(s) is referred to as Δn, and a greater value of Δn generally provides better light extraction. The value of Δn is preferably greater than or equal to 0.3, 0.4, 0.5, or 1.0. Any index mismatch between the extraction elements and backfill medium will provide for light extraction; however, a greater mismatch tends to provide greater light extraction and is thus preferred. Examples of suitable materials for backfill medium 108 include the following: high index inorganic materials; high index organic materials; a nanoparticle filled polymer material; silicon nitride; polymers filled with high index inorganic materials; and high-index conjugated polymers. Examples of high-index polymers and monomers are described in C.Yang, et al., Chem.Mater. 7, 1276 (1995), and R.Burzynski, et al., Polymer 31, 627 (1990) and U.S. Patent No. 6,005,137. Examples of polymers filled with high index inorganic materials are described in U.S. Patent No. 6,329,058. The backfill layer can be applied to form the planarizing layer using, for example, one of the following methods: liquid coating; vapor coating; powder coating; or lamination.

Functionality can be added to the construction by depositing on it a transparent conductor such as ITO (n ≈ 1.9-2.1) with high index, high transparency and low sheet resistivity, to serve as the anode for the OLED device. The ITO can even be used as the backfill for the structure, if the layer can fill the structures and form into a smooth layer without adverse effects on the optical or electrical properties. Alternatively, after backfilling and smoothing, alternating metallic and organic layers may be deposited to form a transparent conductive overlayer in the manner as described in U.S. Patent Application Publication No. 2004/0033369.

Additional flexibility in the functionality of the extractor pattern of the photonic crystal structures or nanostructures can be obtained through the use of photonic quasicrystal structures. These quasicrystal structures are designed using tiling rules; they have neither true periodicity nor translation symmetry but have a quasi-periodicity with long-range order and orientation symmetry, examples of which are described in the following reference: B. Zhang et al., "Effects of the Artificial Ga-Nitride/Air Periodic Nanostructures on Current Injected GaN-Based Light Emitters," Phys.Stat.Sol.(c) 2(7), 2858-61 (2005). The photonic quasicrystal structures offer the possibility of a pseudogap for all propagation directions, and they exhibit unique light scattering behaviors. In particular, these patterns of quasiphotonic crystal structures can eliminate artifacts resulting from the regularity of conventional photonic crystal structures, and they can be used to tailor unique light emission profiles and possibly can eliminate undesirable chromatic effects when working with broadband OLED emitters. Photonic crystal structures are described in the following patents: U.S. Patent Nos. 6,640,034; 6,901,194; 6,778,746; 6,888,994; 6,775,448; and 6,959,127.

Examples can involve the incorporation of the diffractive or scattering nanostructures into a film product which could be continuously produced, for example, on a web line having a polymer film or ultrabarrier coated film substrate fed to a 3C replication process followed by deposition of a high index backfill medium. Alternate ways to incorporate the diffractive or scattering nanoparticles into the film include solution coating a dispersion of particles. This film can be designed to be used directly as the substrate on which a bottom emitting OLED is fabricated, enabling the production of a film capable of many uses in addition to enhancing light extraction.

Additional functionality could be incorporated into the light extraction film product by forming the extraction structures on an optional ultrabarrier film, which provides excellent moisture and oxygen barrier properties. Ultrabarrier films include multilayer films made, for example, by vacuum deposition of two inorganic dielectric materials sequentially in a multitude of layers on a glass or other suitable substrate, or alternating layers of inorganic materials and organic polymers, as described in U.S. Patent Nos. 5,440,446; 5,877,895; and 6,010,751.

Materials may also be incorporated within the film to enhance light extraction through scattering or to filter, color shift, or polarize the light. Finally, surface coatings or structures, for example functional layers 115, can be applied to the air surface of the light extraction film in order to further increase the functionality and possibly value of a light extraction film. Such surface coatings can have, for example, optical, mechanical, chemical, or electrical functions. Examples of such coatings or structures include those having the following functions or properties: antifog; antistatic; antiglare; antireflection; antiabrasion (scratch resistance); antismudge; hydrophobic; hydrophilic; adhesion promotion; refractive elements; color filtering; ultraviolet (UV) filtering; spectral filtering; color shifting; color modification; polarization modification (linear or circular); light redirection; diffusion; or optical rotation. Other possible layers to be applied to the air surface include a barrier layer or a transparent electrically conductive material.

### Top Emitting OLED Display Device

FIG. 2 illustrates a structure of top emitting OLED device 120 with a film substrate having a light extraction film. Table 2 describes the exemplary elements of the device 120 and the arrangement of those elements, as identified by the reference numbers provided in FIG. 2. Each layer of the device can be coated on or otherwise applied to the underlying layer. The configuration shown in FIG. 2 is provided for illustrative purposes only, and other configurations of top emitting OLED display devices are possible.

| Table 2 - Top Emitting OLED Device with Light Extraction Film | |
|---|---|
| Ref. No. | Type of Element |
| 121 | optional functional layers |
| 122 | substrate 1 |
| 124 | optional barrier layer |
| 126 | low index structure |
| 128 | high index structure |
| 130 | optical coupling layer |
| 132 | electrode 1 |
| 134 | thin film encapsulant layer |
| 136 | organic layers |
| 138 | electrode 2 |
| 140 | substrate 2 |
| 142 | light extraction film |

The light extraction film 142 in this embodiment is composed of substrate 122, optional barrier layer 124, low index structure 126, and high index structure 128. Low index structure 126 and high index structure 128 can be implemented with the exemplary materials and constructions described above. The substrates 122 and 140, optional barrier layer 124, electrodes 132 and 138, and organic layers 136 can be implemented with the exemplary materials identified above.

Thin film encapsulant layer 134 can be implemented with, for example, any suitable material for protecting the organic layers from moisture and oxygen. Examples of encapsulants for OLED devices are described in U.S. Patent No. 5,952,778 and U.S. Patent Application Serial No. 11/424997, filed June 19, 2006.

OLED devices, especially top emitting OLED devices as shown in FIG. 2, are completed by depositing a thin film encapsulant on a semitransparent electrode. This construction of an OLED device provides an advantage; in particular it creates access to the critical high index device-air interface after the completion of device fabrication, enabling a lamination process for the application of the light extraction film. For top emitting OLED devices, embodiments include a light extraction film as described above for bottom emitting OLED devices. Alternatively, the film can be designed to be the capping layer on a top emitting OLED structure when combined with a suitable high index adhesive to serve as the optical coupling layer 130 in order to optically couple the OLED device to the light-extracting layer.

### OLED Solid State Lighting Element

Top emitting OLED device 120 can also be used to implement an OLED solid state lighting element. In addition to the substrates identified above, examples of substrates useful in top emitting OLED solid state lighting devices, including flexible metal foils, are described in the following papers: D.U. Jin et al., "5.6-inch Flexible Full Color Top Emission AMOLED Display on Stainless Steel Foil," SID 06 DIGEST, pp. 1855-1857 (2006); and A. Chwang et al., "Full Color 100 dpi AMOLED Displays on Flexible Stainless Steel Substrates," SID 06 DIGEST, pp. 1858-1861 (2006).

FIG. 3 is a diagram illustrating a device 220 having spatially modulated OLED devices for use in solid state lighting devices. Device 220 includes a substrate 222 supporting a plurality of OLED devices 223, 224, 225, and 226, each of which may correspond with the structures described above with respect to top emitting OLED display devices. Each of the OLED devices 223-226 can be individually controlled as represented by lines 228 and 230, which would provide electrical connections to the anodes and cathodes in devices 223-226. Device 220 can include any number of OLED devices 223-226 with electrical connections, and substrate 222 can be scaled to accommodate them. The individual control of devices 223-226, via connections 228 and 230, can provide for spatial modulation of them such that they are individually or in groups lighted in a particular sequence or pattern. Device 220 can be used in solid state light, for example, on a rigid or flexible substrate 222.

### OLED Backlight Unit

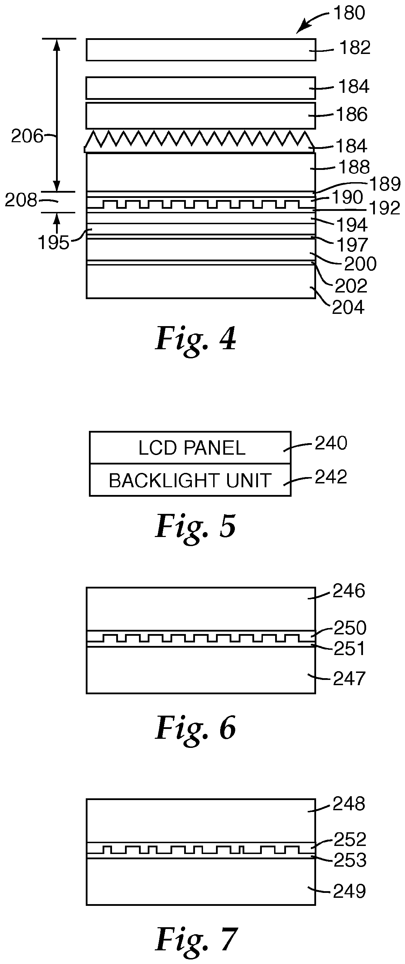

FIG. 4 is a diagram of a top emitting OLED backlight unit 180 with light extraction film. Table 3 describes the exemplary elements of the backlight unit 180 and the arrangement of those elements, as identified by the reference numbers provided in FIG. 4. Each layer of backlight unit 180 can be coated on or otherwise applied to the underlying layer.

| Table 3 - OLED Backlight Unit with Light Extraction Film | |
|---|---|
| Ref. No. | Type of Element |
| 182 | polarizer |
| 184 | optional prism layer |
| 186 | optional asymmetric reflective film |
| 188 | optional diffuser |
| 189 | substrate 1 |
| 190 | low index structure |
| 192 | high index structure |
| 194 | optical coupling layer |
| 195 | thin film encapsulant layer |
| 197 | electrode 1 |
| 200 | organic layers |
| 202 | electrode 2 |
| 204 | substrate 2 |
| 206 | auxiliary optical films |
| 208 | light extraction film |

The light extraction film 208 in this embodiment is composed of optional prism layer 184, optional diffuser 188, low index structure 190, and high index structure 192. Low index structure 190 and high index structure 192 can be implemented with the exemplary materials and constructions described above. The other elements of this embodiment, as provided in Table 3, can be implemented with the exemplary materials identified above.

FIG. 5 is a diagram illustrating OLED devices used as a liquid crystal display (LCD) backlight unit 242 for an LCD panel 240. Backlight unit 242 may correspond with the structure 180. The backlight unit 242 can alternatively be implemented with the spatially modulated light panel shown in FIG. 3. LCD panel 240 typically includes the entire LCD device except the backlight and drive electronics. For example, LCD panel 240 typically includes the backplane (subpixel electrodes), front and back plates, liquid crystal layer, color filter layer, polarizing filters, and possibly other types of films. Use of OLED devices as a backlight may provide for a thin, low power backlight for LCDs. An example of LCD panel components and a backlight unit are described in U.S. Patent No. 6,857,759.

### High Index/Low Index Regions and Surface Configurations

FIGS. 6-9 are diagrams depicting the possible spatial configurations of extraction elements. FIG. 6 illustrates a low index structure 250, having a regular pattern of nanostructures, with a high index structure 251 providing a planarizing layer over the nanostructures. The structures 250 and 251 are located between a low index substrate 246 and an OLED device region 247. FIG. 7 illustrates a low index structure 252, having an irregular pattern of nanostructures, with a high index structure 253 providing a planarizing layer over the nanostructures. The structures 252 and 253 are located between a low index substrate 248 and an OLED device region 249. In FIGS. 6 and 7, the low and high index structures are located between a substrate and an OLED device (light emitting) region.

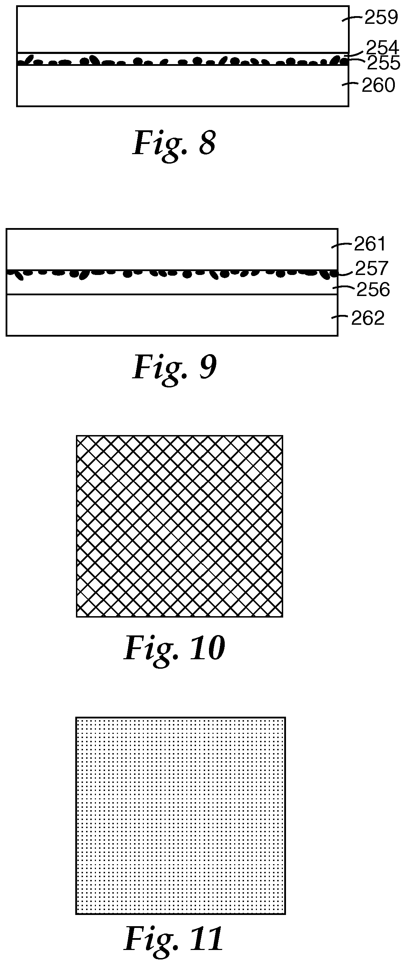

FIG. 8 illustrates high index extraction elements 255 within a low index backfill region 254 with the low index region 254 providing the planarizing layer. The extraction elements 255 and backfill 254 are located between a low index substrate 260 and an OLED device region 259. FIG. 9 illustrates low index extraction elements 257 within a high index backfill region 256 with the high index region 256 providing the planarizing layer. The extraction elements 257 and backfill 256 are located between a low index substrate 261 and an OLED device region 262. In the embodiments shown in FIGS. 8 and 9, the extraction elements are concentrated in the evanescent zone. The layers shown in FIGS. 6-9 illustrate patterns and interfaces of the low index and high index structures described above.

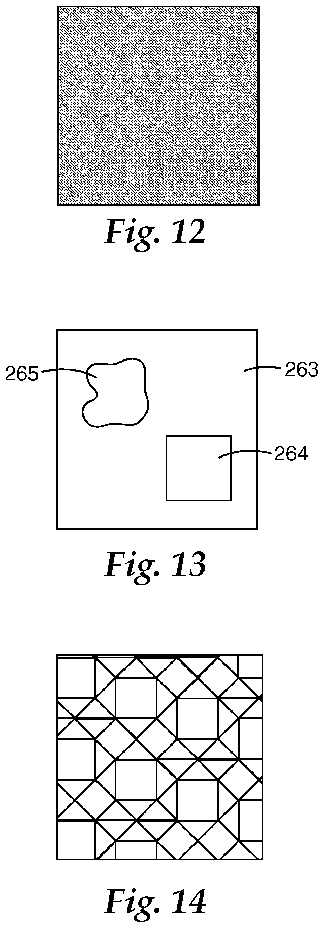

FIGS. 10-14 are top view diagrams depicting possible surface configurations of extraction elements. FIGS. 10 and 11 illustrate regular periodic arrays of extraction elements. FIG. 12 illustrates a random distribution of extraction elements. FIG. 13 illustrates patterned regions of extraction elements. In particular, FIG. 13 illustrates portions of features, possibly in a regular pattern 264 or an irregular pattern 265, interspersed within a different distribution of features 263. The regular or irregular patterns 264 and 265, respectively, along with the different distribution 263 may each have periodic, quasi-periodic, or random distributions of extraction elements. Such regions of patterns may be useful to optimize extraction of particular wavelengths of light at those regions, for example wavelengths corresponding with red, green, and blue light. In that case, the extraction regions can correspond and be aligned the red, green, and blue regions comprising pixels of a display device, and each extraction region can each be optimized to extract light from the corresponding red, green, and blue regions. FIG. 14 illustrates quasicrystal (tiled patterns) of extraction elements.

Examples of techniques for making extraction elements are described in U.S. Patent Application Serial No. 11/556719, filed November 6, 2006. FIGS. 10-14 illustrate possible surface configurations of the nanostructures or other extraction elements described above with a backfill medium providing the planarizing layer over the nanostructures.

Additional techniques could include using lithography or interference lithography to expose nanoscale regions in a photosensitive polymer deposited on a flexible polymer web. After the exposure and development steps, the remaining photosensitive polymer would then define a nanostructured surface. Alternatively, this nanostructured photosensitive polymer surface can serve as an etch mask for exposure of the surface in an etching process. This etching technique would transfer the nanoscale pattern into the surface of the underlying polymer web or into a layer of a harder material, such as a silicon oxide, which had been deposited on the polymer web prior to the lithographic steps. The nanoscale surface defined in any of these manners could then be backfilled with an.index contrasting medium to form the light scattering or diffracting layer.

### Distributions of Nanoparticles for Light Extraction

This embodiment provides enhanced light extraction from an OLED using an index-contrasting film with randomly distributed high index nanostructures created by coating nanoparticles such as, for example, ITO, silicon nitride (Si₃N₄, referred to here as SiN), CaO, Sb₂O₃, ATO, TiO₂, ZrO₂, Ta₂O₅, HfO₂, Nb₂O₃, MgO, ZnO, In₂O₃, Sn₂O₃, AlN, GaN, TiN, or any other high index materials on a substrate used in OLED fabrication or encapsulation, and then applying a low index coating, such as SiO₂, Al₂O₃, DLG, DLC, or polymeric materials over the nanoparticles to provide the index contrast needed for scattering or diffraction efficiency and to planarize the surface. The randomly distributed nanostructures can be in contact with the substrate, proximate the substrate, grouped together in places, or in any random configuration proximate the substrate. A converse construction, potentially providing similar effectiveness, can comprise a random distribution of low index nanoparticles or nanostructures such as SiO₂, porous SiO₂, Borosilicate (BK), Al₂O₃, MgF₂, CaF, LiF, DLG, DLC, poly(methyl methacrylate) (PMMA), polycarbonate, PET, low index polymers, or any other low index materials with a contrasting high index filler material such as vapor deposited Si₃N₄ or a solvent-coated particle-filled polymer or a high index polymer.

Coating processes such as spin coating, dip coating, and knife coating may be used for distributing the nanoparticles on the surface, and a similar process may be used to coat the backfill/planarization layer. The use of such techniques should render the process simple, easily scaled for manufacturing, and suitable for incorporation in film products manufactured via web line or roll-to-roll processes.

One particular method involves applying nanoparticles having a first index of refraction onto a flexible substrate and overcoating a backfill layer on the nanoparticles to form a planarizing layer over them. The backfill layer comprises a material having a second index of refraction different from the first index of refraction. Preferably, a substantial portion of the nanoparticles are within an evanescent zone adjacent to a light emitting region of a self-emissive light source when the optical film is located against the self-emissive light source. For example, a substantial portion of the nanoparticles can be in contact with the substrate to be within the evanescent zone, although in some embodiments the substantial portion of the nanoparticles in the evanescent zone need not be in contact with the substrate.

Applying the nanoparticles can involve coating the nanoparticles dispersed in a solvent onto the flexible substrate and allowing the solvent to evaporate before overcoating the backfill layer. Applying the nanoparticles can also involve applying them in dry form to the flexible substrate and then overcoating them with the backfill layer. An alternative to the method involves using substrate with a release agent, in which the particles are applied to a substrate with a release agent, the substrate with the particles is applied to a device substrate with the particles in contact with it, and then the substrate is released to transfer the particles to the device substrate.

### Replication Method

One solution for forming a master tool having nanostructures involves the use of interference lithography. Regular periodic features as small as 100nm-150nm can be quickly written using this method. An advantage involves being able to write these patterns over larger areas, which can make the process more amenable to manufacturing.

Production of a master tool for replication of the pattern can involve the following. A substrate is coated with an overlayer of photoresist and then illuminated with one or more UV interference patterns to expose the resist in a regular pattern with the desired feature sizes. Development of the resist then leaves an array of holes or posts. This pattern can subsequently be transferred into the underlying substrate through an etching process. If the substrate material is not suitable to be used as a replication tool, a metal tool can be made using standard electroforming processes. This metal replica would then become the master tool.

Another method involves forming a master tool having randomly-distributed nanostructures. A solution is prepared comprising nanoparticles of the appropriate size and with the appropriate surface modifications to prevent agglomeration. Methods for preparing such solutions are generally specific to the particular nanoparticles to be dispersed; general methods have been described elsewhere, including U.S. Patent No. 6,936,100 and Molecular Crystals and Liquid Crystals, 444 (2006) 247-255. The solution is then coated onto a flexible substrate using one of a variety of solvent coating techniques, including knife coating, dip coating, or spray coating. Pretreatment of the substrate using methods such as plasma etching may be required in order to assure uniformity of the solution coating. After solvent evaporation, the nanoparticles should be distributed in a way that is microscopically random but macroscopically uniform. As was the case with the uniform tool fabrication process described above, this pattern could then be transferred to an underlying substrate material through an etching or embossing process, or a metal tool can be made using standard electroforming processes.

In any of these cases, if a flat master tool has been produced, it or its replicas may then be tiled together to form a larger tool, as described in U.S. Patent No. 6,322,652, or may be formed into a cylindrical tool for compatibility with a roll-to-roll replication process.

Once a master tool has been produced, replication of the structure into a polymer can be done using one of a variety of replication processes, including the 3C process. The substrate for this replication could be any polymer sheeting compatible with the chosen replication process; it may be already coated with the ultrabarrier film as described above. Backfilling would then be performed downstream in, for example, a chemical vapor deposition (CVD) or sputtering process which can deposit a high index material, such as SiN or ITO, which is capable of filling the structures and then leveling out into a smooth layer. If SiN is used, this might then be followed by an ITO deposition process if a conductive upper layer is required. Alternatively, the downstream backfilling may be performed in a solvent coating process using suitable materials.

### Examples

Table 4 provides definitions and sources for materials used in the Examples.

| Table 4 |
|---|
| Tetrafluorotetracyanoquinodimethane (FTCNQ, TCI America, Portland, Oregon) |
| 4,4',4"-Tris(N-(3-methylphenyl)-N-phenylamino)triphenylamine (MTDATA, H. W. Sands Corp., Jupiter, Florida) |
| Aluminum tris(8-hydroxyquinolate) (AlQ, H. W. Sands Corp., Jupiter, Florida) |
| N,N'-bis(naphthan-2-yl)-N,N'-bis(phenyl)benzidine (NPD, H. W. Sands Corp., Jupiter, Florida) |
| Coumarin 545T dye (C545T, Eastman Kodak Co., Rochester, New York) |
| Lithium fluoride (LiF, Alfa Aesar Co., Ward Hill, Massachusetts) |
| Aluminum (Al, Alfa Aesar Co., Ward Hill, Massachusetts) |

### Example 1 - Periodic array of low index nanostructures with thick high index vapor-deposited backfill

A regular periodic array of nanostructures was produced in a low-index polymer layer using interference lithography. It is known that, for 2-beam interference, the peak-to-peak spacing of the fringes is given by (λ/2)/sin(θ/2), where λ is the wavelength and θ is the angle between the two interfering waves. This technique enables patterning of structures down to periods as small as one half of the exposing wavelength.

For this example, a thin film of UV-sensitive photoresist (PR) was spun onto a thin glass substrate. The PR was then exposed by a two-beam interference pattern from a 325nm argon ion laser; the periodic patterns of high and low intensity created lines of exposed regions of period 520nm in the PR. The substrate was then rotated by 90 degrees and another exposure was made. This resulted, after development, in a pattern of square holes in the PR with hole spacing of 520nm, hole dimension approximately 250nm, and hole depth approximately 200nm. This pattern was then backfilled with plasma-enhanced chemical vapor deposition (PECVD) Si₃N₄ to a thickness of 1000nm in the manner described in Example 3.

### Example 2 - Periodic array of low index nanostructures with thinned high index planarization vapor-deposited backfill

In order to obtain a higher degree of planarization, a thick (1.3 microns) layer of photoresist (such as Shipley PR1813 available from Electronic Materials Inc., Spartanburg, SC) was coated on the SiN layer by spin coating using a substrate as prepared in Example 1. Then reactive ion etching (RIE) was performed to etch away the PR and part of the SiN. A reactive ion etch (RIE, Model PlasmaLab™ System 100 available form Oxford Instruments, Yatton, UK) was performed according to the conditions described in Table 5.

| Table 5 - Materials/Conditions used for Reactive Ion Etching | |
|---|---|
| Reactant/Condition | Value |
| C₄F₈ | 10-50 sccm (standard cubic centimeters per minute) |
| O₂ | 0.5-5 sccm |
| RF power | 50-100W |
| Inductive Coupling Plasma (ICP) power | 1000-2000 W |
| Pressure | 3-10 mTorr |

This light extraction structure then served as the substrate for deposition of a bottom emitting green OLED in a manner similar to that described in Example 3 except that ITO covered the entire substrate. In this case, the OLED layers were deposited through a 40 millimeters (mm) x 40mm shadow mask in the following order: 3000Å MTDATA doped with 2.8% FTCNQ/400Å NPD/300Å AlQ doped with 1% C545T/200Å AlQ/7Å LiF. The 40mm x 40mm shadow mask was replaced by a mask containing several parallel 3mm x 25mm openings and through which 2500Å of Al cathode metal was then deposited. This provided OLED devices containing several independently addressable 3mm x 25mm pixels.

Light emitted from the cathode stripe from the resulting OLED was observed. The cathode stripe passes over areas with and without the periodic patterns, enabling observation of patterned and unpatterned regions simultaneously, with the same voltage applied across both regions. It was quite apparent that the area with the periodic patterns was brighter than the area without the periodic patterns.

### Example 3 - Random distribution of low-index nanoparticles with high-index planarization layer

A coating of nanoparticles (NPs) was created on a 50mm x 50mm glass substrate by applying a commercially-obtained sol of silica (SiO₂) NPs to the substrate and drying at 100°C for 5 minutes. The sol consisted of 46 weight percent of SiO₂ nanoparticles suspended in water solution (available from Nalco Company, 1601W. Diehl Rd., Naperville, IL 60563-1198). The particle size in this sol ranges from a 60nm-300nm diameter, with an average diameter of 244nm. Alternatively, it is possible to use particles having at least one dimension (e.g., diameter) in the range 20nm-1000nm.

After coating the part of the glass substrate with the nanoparticles, a 300nm thick layer of silicon nitride (Si₃N₄) was coated onto the SiO₂-NPs and bare glass portions of the substrate by plasma-enhanced chemical vapor deposition (PECVD, Model PlasmaLab™ System 100 available form Oxford Instruments, Yatton, UK), using the parameters described in Table 6.

| Table 6 - Conditions used for depositing SiN layer | |
|---|---|
| Reactant/Condition | Value |
| SiH₄ | 400 sccm |
| NH₃ | 20 sccm |
| N₂ | 600 sccm |
| Pressure | 650 mTorr |
| Temperature | 60°C |
| High frequency (HF) power | 20W |
| Low frequency (LF) power | 20W |

The refractive index of the SiN core layer was measured using a Metricon Model 2010 Prism Coupler (Metricon Corporation; Pennington, N.J.) and was found to be 1.8. SEM imaging of the resultant SiN surface indicated that the roughness of the SiO₂ NP surface had been reduced considerably by the 300nm SiN coating, although residual deviations remained.

In order to incorporate the index-contrasted nanostructured light-scattering layer into an OLED, 110nm of ITO was deposited on the SiN through a 5mm x 5mm pixilated shadow mask to serve as the OLED anode. Subsequently a simple green organic emitting layer and cathode were deposited to complete the OLED. The OLEDs were fabricated by standard thermal deposition in a bell-jar vacuum system. The OLED layers were deposited through a 40mm x 40mm shadow mask covering the 5mm x 5mm ITO pixels in the following order: 3000Å MTDATA doped with 2.8% FTCNQ/400Å NPD/300Å AlQ doped with 1% C545T/200Å AlQ/7Å LiF. The 5mm x 5mm shadow mask was then realigned and 2500Å of Al metal was deposited to form the cathodes contacting the tops of the pixels. This provided OLED devices containing several independently addressable 5mm x 5mm pixels with some pixels disposed over nanoparticles and other pixels not disposed over the nanoparticles.

Light emitted from the cathodes of the resulting OLEDs was observed. It was apparent that these devices with the nanoparticle coating were qualitatively brighter than the devices prepared under identical conditions but without nanoparticle coatings. Subsequent quantitative measurements on these devices have borne out these results. Significant increases in brightness have been observed for modified devices over those with no modification of the interface, whether driving the devices at the same voltage or the same current. Efficiency measurements (candelas per ampere) show an improvement of about 40% with this simple modification.

### Example 4 - Random distribution of high index nanoparticles with low index backfill

A coating of high index NPs was created on a glass substrate by applying a commercially-obtained sol of ITO NPs to the substrate and drying at 100°C for 5 minutes. The sol consisted of 20 weight percent of ITO nanoparticles suspended in a 1:1 isopropanol/water solution (Advanced Nano Products Co., LTD., Chungwon-kun, Chungcheonbuk-do, Korea). The particle size in this sol ranges from a 30nm-300nm diameter, with an average diameter of 86nm. After coating a portion of the glass substrate with the nanoparticles, a 200nm-400nm thick layer of silicon oxide was coated onto the ITO-NPs and bare glass portions of the substrate by plasma-enhanced chemical vapor deposition (PECVD, Model PlasmaLab™ System100 available form Oxford Instruments, Yatton, UK), using the parameters described in Table 7.

| Table 7 - Conditions used for depositing SiO₂ layer | |
|---|---|
| Reactant/Condition | Value |
| SiH₄ | 200-400 sccm |
| N₂O | 500-1500 sccm |
| N₂ | 200-800 sccm |
| Pressure | 400-1600 mTorr |
| Temperature | 60°C |
| High frequency (HF) power | 50-150W |

With these parameters, a refractive index of 1.46 can be achieved for the silicon oxide film; the index of the ITO NPs is approximately 1.95. At the completion of the PECVD process, high-index nanoparticles with low-index backfill had been generated. Subsequent deposition of an OLED device on this modified substrate resulted in significant enhancement of the light extracted from the portions of the device that had been patterned with NPs when compared to the unpatterned portions. Efficiency measurements (candelas per ampere) show an improvement of about 60-80% with this simple modification.

### Example 5 - Production of nanoscale structures on flexible sheet with barrier coating

The experiment began with a film on which oxygen/moisture barrier layers had previously been deposited. This barrier film typically comprises PET overcoated with a first polymer layer and further overcoated with at least two visible light-transmissive inorganic barrier layers separated by at least one second polymer layer. Such barrier films have demonstrated oxygen transmission rates less than 0.005 cc/m²/day at 23°C and 90% relative humidity and are described in greater detail in, for example, U.S. Patent Nos. 7,018,713 and 6,231,939.

Samples of these barrier films were cut into small 1 inch x 1 inch pieces and cleaned with methanol and distilled water. A layer of photoresist (Shipley UV5) was deposited and then baked at 135°C for 60 seconds, producing a coating of thickness 0.56 microns. This sample was then exposed to interfering laser beams as described in Example 1 above to produce a square array of exposed elements. The resulting pattern had a periodicity of 1.6 microns in each direction and a duty cycle of approximately 50%. The sample was then placed on a hot plate and baked at 130°C for 90 seconds. After the sample cooled down it was then place in a developer bath (MF-CD-26 from Rohm&Haas) for 10 seconds with stirring. After drying in air for about 3 hours, the samples were then heated on a hot plate at 130°C for 1 minute to remove any residual moisture.

The resulting film is an example of nanostructures useful for light extraction disposed on a flexible substrate with an interposed barrier layer. This film corresponds with elements 110, 112 and 114 in FIG. 1 and with elements 126, 124 and 122 in FIG. 2.

### Example 6 - Random distribution of high index nanoparticles with low index backfill on flexible sheet with barrier coating

The experiment began with a film on which oxygen/moisture barrier layers had previously been deposited. This barrier film typically comprises PET flexible sheet overcoated with a first polymer layer and further overcoated with at least two visible light-transmissive inorganic barrier layers separated by at least one second polymer layer. Such barrier films have demonstrated oxygen transmission rates less than 0.005 cc/m²/day at 23°C and 90% relative humidity and are described in greater detail in, for example, U.S. Patent Nos. 7,018,713 and 6,231,939.

Samples of these barrier films were cut into small 2 inch x 2 inch pieces. A dip-coating of high index NPs was created on the flexible sheet by applying a commercially-obtained sol of ITO NPs to the substrate and drying at 100°C for 5 minutes. The sol consisted of 20 weight percent of ITO nanoparticles suspended in a 1:1 isopropanol/water solution (Lot-3M-060330-1, Advanced Nano Products Co., LTD.Chungwon-kun, Chungcheonbuk-do, Korea). The particle size in this sol ranges from a 30nm-300nm diameter, with an average diameter of 86nm. After coating a portion of the flexible sheet substrate with the nanoparticles, a 200nm-400nm thick layer of silicon oxide was coated onto the ITO-NPs and bare flexible sheet portions of the substrate by plasma-enhanced chemical vapor deposition (PECVD, Model PlasmaLab™ System 100 available form Oxford Instruments, Yatton, UK), using the parameters described in Table 7.

With these parameters, a refractive index of 1.46 can be achieved for the silicon oxide film; the index of the ITO NPs is approximately 1.95. At the completion of the PECVD process, high-index nanoparticles with low-index backfill had been generated. Subsequent deposition of an OLED device on this modified substrate resulted in significant enhancement of the light extracted from the portions of the device that had been patterned with NPs when compared to the unpatterned portions.

Subsequent quantitative measurements on these devices have borne out these results. Significant increases in brightness have been observed for modified devices over those with no modification of the interface, whether driving the devices at the same voltage or the same current. Efficiency measurements (candelas per ampere) show an improvement of about 100% with this simple modification.

## Claims

1. An organic light emitting diode (OLED) device, comprising:
a self-emissive light source comprising electrodes (138, 132) and organic layers (136) and having at least one surface that outputs light; and
a light extraction film (142) adjacent the at least one surface of the self-emissive light source, wherein the light extraction film comprises:
a flexible substrate (122) substantially transmissive to light emitted by the self-emissive light source;
a structured layer (126) of extraction elements disposed on the substrate and having a first index of refraction,
wherein the extraction elements comprise a nanostructured surface of the structured layer on a side of the structured layer opposite the substrate,
wherein the nanostructured surface comprises engineered features in the structured layer;
a backfill layer (128) comprising a material having a second index of refraction different from the first index of refraction, wherein the backfill layer forms a planarizing layer over the nanostructured surface, forming a planar surface on a side of the backfill layer opposite the nanostructured surface, wherein the backfill layer comprises a nanoparticle filled polymer material,
wherein a substantial portion of the extraction elements are within an evanescent zone of the light output surface of the self-emissive light source when the planar surface of the backfill layer is located against the light output surface of the self-emissive light source, and
wherein the structured layer and backfill layer are in sufficient proximity to the light output surface of the self-emissive light source in order to at least partially enhance the extraction of light from the light output surface; **characterized by**
an optical coupling layer (130) located on the planar surface of the backfill layer, wherein the optical coupling layer comprises an adhesive providing for optical coupling between the light output surface of the self-emissive light source and the backfill layer, and
a thin film encapsulant layer (134) formed on an electrode (132) of the self-emissive light source adjacent to the light extraction film for protecting the organic layers of the self-emissive light source from moisture and oxygen.

2. The OLED device of claim 1, wherein the engineered features comprises a nanoscale pattern in the structured layer.

3. The OLED device of claim 1, wherein the engineered features comprise a pattern of holes in the structured layer.

4. The OLED device of claim 1, wherein the engineered features comprise photonic crystal structures.

5. The OLED device of claim 1, wherein the engineered features have a periodic distribution.

6. The OLED device of claim 1, wherein the engineered features have a quasi-periodic distribution.

7. The OLED device of claim 1, wherein the engineered features have a random distribution.

## Patentansprüche

1. Organische Leuchtdioden-(OLED-)Vorrichtung, aufweisend:
eine selbstemittierenden Lichtquelle, die Elektroden (138, 132) und organische Schichten (136) aufweist und mindestens eine Oberfläche hat, die Licht emittiert; und
eine Lichtauskopplungsfolie (142) angrenzend an die mindestens eine Oberfläche der selbstemittierenden Lichtquelle, wobei die Lichtauskopplungsfolie aufweist:
ein elastisches Substrat (122), das im Wesentlichen durchlässig für Licht ist, das von der selbstemittierenden Lichtquelle emittiert wird;
eine strukturierte Schicht (126) von Auskopplungselementen, die auf dem Substrat angeordnet sind und einen ersten Brechungsindex haben,
wobei die Auskopplungselemente eine nanostrukturierte Oberfläche der strukturierten Schicht auf einer Seite der strukturierten Schicht gegenüber dem Substrat aufweisen,
wobei die nanostrukturierte Oberfläche konstruierte Merkmale in der strukturierten Schicht aufweist;
eine Hinterfüllungsschicht (128), die ein Material mit einem zweiten Brechungsindex aufweist, der von dem ersten Brechungsindex verschieden ist, wobei die Hinterfüllungsschicht eine Planarisierungsschicht über der nanostrukturierten Oberfläche bildet, die eine planare Oberfläche auf einer Seite der Hinterfüllungsschicht gegenüber der nanostrukturierten Oberfläche bildet, wobei die Hinterfüllungsschicht ein mit Nanoteilchen gefülltes Polymermaterial aufweist,
wobei sich ein wesentlicher Anteil der Auskopplungselemente innerhalb einer evaneszenten Zone der Lichtaustrittsfläche der selbstemittierenden Lichtquelle befindet, wenn die planare Oberfläche der Hinterfüllungsschicht an der Lichtaustrittsfläche der selbstemittierenden Lichtquelle angeordnet ist, und
wobei sich die strukturierte Schicht und die Hinterfüllungsschicht in ausreichender Nähe zur Lichtaustrittsfläche der selbstemittierenden Lichtquelle befinden, um die Lichtauskopplung von der Lichtaustrittsfläche zumindest teilweise zu verbessern; **gekennzeichnet durch**
eine optische Kopplungsschicht (130), die auf der planaren Oberfläche der Hinterfüllungsschicht angeordnet ist, wobei die optische Kopplungsschicht einen Klebstoff umfasst, der die optische Kopplung zwischen der Lichtaustrittsfläche der selbstemittierenden Lichtquelle und der Hinterfüllungsschicht bereitstellt, und
eine Dünnfilm-Kapselungsschicht (134), die auf einer Elektrode (132) der selbstemittierenden Lichtquelle angrenzend an die Lichtauskopplungsfolie zum Schutz der organischen Schichten der selbstemittierenden Lichtquelle vor Feuchtigkeit und Sauerstoff ausgebildet ist.

2. OLED-Vorrichtung nach Anspruch 1, wobei die konstruierten Merkmale ein Muster im Nanobereich in der strukturierten Schicht aufweisen.

3. OLED-Vorrichtung nach Anspruch 1, wobei die konstruierten Merkmale ein Lochmuster in der strukturierten Schicht aufweisen.

4. OLED-Vorrichtung nach Anspruch 1, wobei die konstruierten Merkmale photonische Kristallstrukturen aufweisen.

5. OLED-Vorrichtung nach Anspruch 1, wobei die konstruierten Merkmale eine periodische Verteilung aufweisen.

6. OLED-Vorrichtung nach Anspruch 1, wobei die konstruierten Merkmale eine quasi-periodische Verteilung aufweisen.

7. OLED-Vorrichtung nach Anspruch 1, wobei die konstruierten Merkmale eine willkürliche Verteilung aufweisen.

## Revendications

1. Dispositif de diode électroluminescente organique (DELO), comprenant :
une source de lumière à auto-émission comprenant des électrodes (138, 132) et des couches organiques (136) et ayant au moins une surface qui délivre en sortie de la lumière ; et
un film d'extraction de lumière (142) adjacent à l'au moins une surface de la source de lumière à auto-émission, dans lequel le film d'extraction de lumière comprend :
un substrat flexible (122) essentiellement transmissif à de la lumière émise par la source de lumière à auto-émission ;
une couche structurée (126) d'éléments d'extraction disposés sur le substrat et ayant un premier indice de réfraction,
dans lequel les éléments d'extraction comprennent une surface nanostructurée de la couche structurée sur un côté de la couche structurée opposé au substrat,
dans lequel la surface nanostructurée comprend des caractéristiques artificiellement modifiées dans la couche structurée ;
une couche de remplissage (128) comprenant un matériau ayant un deuxième indice de réfraction différent du premier indice de réfraction, dans lequel la couche de remplissage forme une couche de planarisation par-dessus la surface nanostructurée, formant une surface plane sur un côté de la couche de remplissage opposé à la surface nanostructurée, dans lequel la couche de remplissage comprend un matériau polymère chargé en nanoparticules,
dans lequel une partie importante des éléments d'extraction est au sein d'une zone évanescente de la surface de sortie de lumière de la source de lumière à auto-émission lorsque la surface plane de la couche de remplissage se trouve contre la surface de sortie de lumière de la source de lumière à auto-émission, et
dans lequel la couche structurée et la couche de remplissage sont à proximité suffisante de la surface de sortie de lumière de la source de lumière à auto-émission afin de renforcer au moins partiellement l'extraction de lumière à partir de la surface de sortie de lumière ; **caractérisé par**
une couche de couplage optique (130) située sur la surface plane de la couche de remplissage, dans lequel la couche de couplage optique comprend un adhésif assurant un couplage optique entre la surface de sortie de lumière de la source de lumière à auto-émission et la couche de remplissage, et
un agent d'encapsulation à film mince (134) formé sur une électrode (132) de la source de lumière à auto-émission adjacente au film d'extraction de lumière pour protéger les couches organiques de la source de lumière à auto-émission de l'humidité et de l'oxygène.

2. Dispositif DELO selon la revendication 1, dans lequel les caractéristiques artificiellement modifiées comprennent un motif à l'échelle nanométrique dans la couche structurée.

3. Dispositif DELO selon la revendication 1, dans lequel les caractéristiques artificiellement modifiées comprennent un motif de trous dans la couche structurée.

4. Dispositif DELO selon la revendication 1, dans lequel les caractéristiques artificiellement modifiées comprennent des structures de cristal photonique.

5. Dispositif DELO selon la revendication 1, dans lequel les caractéristiques artificiellement modifiées ont une distribution périodique.

6. Dispositif DELO selon la revendication 1, dans lequel les caractéristiques artificiellement modifiées ont une distribution quasi périodique.

7. Dispositif DELO selon la revendication 1, dans lequel les caractéristiques artificiellement modifiées ont une distribution aléatoire.
